Europäisches Patentamt

European Patent Office

Office européen des brevets

(11) Veröffentlichungsnummer: **0 450 165 A2**

# EUROPÄISCHE PATENTANMELDUNG

(21) Anmeldenummer: **90123707.3**

(22) Anmeldetag: **10.12.90**

(51) Int. Cl.5: **C23C 16/50**

(30) Priorität: **03.04.90 DE 4010663**

(43) Veröffentlichungstag der Anmeldung:
**09.10.91 Patentblatt 91/41**

(84) Benannte Vertragsstaaten:
**BE DE ES FR IT NL SE**

(71) Anmelder: **LEYBOLD AKTIENGESELLSCHAFT**
**Wilhelm-Rohn-Strasse 25**
**W-6450 Hanau am Main 1(DE)**

(72) Erfinder: **Geisler, Michael, Dr.**
**Chatilloner Strasse 29**
**W-6480 Waechtersbach(DE)**
Erfinder: **Koetter-Faulhaber, Rudolf**
**Rodheimer Strasse 2**
**W-6367 Karben 6(DE)**
Erfinder: **Jung, Michael**
**Richard-Wagner-Strasse 5**
**W-8756 Kahl/Main(DE)**

(54) **Verfahren und Vorrichtung zur Beschichtung von Vorderflächenspiegeln.**

(57) Vorrichtung und Verfahren zur Herstellung von Schichten auf der Oberfläche von Werkstücken, vorzugsweise von aus Kunststoffen gebildeten Scheinwerfer-Reflektoreinsätzen, in einer als Batch-Anlage zu betreibenden Vakuumkammer (1) mit einem PCVD-Beschichtungsverfahren, wobei eine Mikrowellen-ECR-Plasmabeschichtungsquelle eingesetzt wird und die zu beschichtenden Vorderflächenspiegel (9, 9', ...) an einem in der Vakuumkammer befindlichen Drehkäfig (8) befestigt sind, der mit einer frequenz- und phasenabgestimmten Planetenbewegung an einer Beschichtungsquelle vorbeiführbar ist und daß die Beschichtungsprozesse, wie beispielsweise die Metallisierung der Substratoberfläche durch eine aufzubringende Aluminiumschicht in der Vakuumkammer (1) unter Plasma und bei Drücken unterhalb von $2 \times 10^{-2}$ mbar durchführbar sind.

## FIG.1

EP 0 450 165 A2

Die Erfindung betrifft ein Verfahren und eine Vorrichtung zur Herstellung von Schichten auf der Oberfläche von Werkstücken, vorzugsweise von aus Kunststoffen gebildeten Scheinwerfer-Reflektoreinsätzen, in einer als Batchanlage zu betreibenden Vakuumkammer mit einem PCVD-Beschichtungsverfahren, wobei eine Mikrowellen-ECR-Plasmabeschichtungsquelle eingesetzt wird und die zu beschichtenden Vorderflächenspiegel an einem in der Vakuumkammer befindlichen Drehkäfig befestigt sind, der mit einer frequenz- und phasenabgestimmten Planetenbewegung an der Beschichtungsquelle vorbeigeführt wird.

Bekannt ist eine Einrichtung zum Herstellen eines Plasmas und zur Behandlung von Substraten darin (P 37 05 666.2), in der mit Hilfe einer Mikrowellen-ECR-Plasmaquelle ein Beschichtungsprozeß von beispielsweise bandförmigem Substrat durchgeführt wird.

Weiterhin ist ein Verfahren und eine Vorrichtung zur Herstellung einer korrosionsfesten Schicht auf der Oberfläche von mit Lack überzogenen Werkstücken bekannt (DE 37 31 686), bei dem in einer Vakuumkammer mit Hilfe einer Glimmkathode und einem Verdampfer ein Schichtsystem auf die Werkstücke aufgebracht wird.

Bei diesem vorbekannten Verfahren bestehen die für den Korrosionsschutz geeigneten Schichten aus elektrisch nicht bzw. äußerst schlecht leitendem Material. Oberhalb einer Dicke von etwa 100 bis 200 nm sind diese Schichten gute Isolatoren. Beim Betrieb der herkömmlichen Anlagen zur Schutzbeschichtung von Kfz-Reflektoren, die mit Gleichspannung betrieben werden, bilden sich während des Beschichtungsprozesses insbesondere auf den Elektroden stetig wachsende Schichten, die innerhalb kurzer Zeit die für die elektrische Leitfähigkeit kritische Dicke erreicht haben und isolierend werden. Sie verhindern damit die Aufrechterhaltung der mit Gleichspannung betriebenen Glimmentladung. Zur wiederaufbereitenden Reinigung der Elektroden muß die Prozeßkammer nach jeder Charge, also in kurzen Abständen geflutet werden. Erfahrungsgemäß ist das Fluten einer Prozeßkammer immer mit einer enormen Partikelgeneration begleitet, die jedesmal eine aufwendige Reinigung der gesamten Prozeßkammer notwendig macht. Der Betrieb einer Gleichspannungs-(DC-)PCVD-Anlage ist daher sehr personal- und kostenintensiv. Die DC-PCVD-Technik ist aufgrund des Prozeßdruckbereiches von einigen Millibar und des dadurch bedingten Partikelanteils nicht in-line-fähig.

Des weiteren wird aus dem oben Gesagten ohne weiteres auch klar, daß eine DC-Plasmapolymerisationsanlage keine Schichten einer größeren Dicke als etwa 100 nm zuverlässig herstellen kann.

Die bei der DC-PCVD eingesetzte DC-Glimmentladung wird im Druckbereich von einigen Millibar betrieben. Die Strömungsverhältnisse sind in diesem Druckbereich in jedem Falle hochviskos, turbulent und daher weder über-schau- noch beherrschbar. Unter diesem Verhältnissen eine gleichmäßige Schichtdickenverteilung zu schaffen ist praktisch nicht möglich.

Ein kaum zu überschätzender Nachteil des herkömmlichen Verfahrens ist auch, daß Reflektorgrundkörper, deren Vorlackierung ein Alter von einigen Stunden besitzt, nicht mehr zufriedenstellend haftfest aluminisiert und schutzbeschichtet werden können; die Reflektorgrundkörper müssen kurz nach ihrer Vorlackierung weiterverarbeitet werden. Dies ist eine erheblicher Nachteil des Beschichtungsverfahrens, da eine Zwischenlagerung zwischen den Produktionsschritten des Vorlackierens und den Vakuumbeschichtungen nicht möglich und demzufolge beide Prozesse innerhalb des Produktionsablaufes sehr zeitkritisch werden.

Ziel der vorliegenden Erfindung ist es, Vorrichtungen und Verfahren zu entwickeln, die es gestatten, im kontinuierlichen, kostengünstigen Betrieb dielektrische Schichten beliebiger Dicke abzuscheiden. Ein weiteres Ziel der Erfindung ist es, die mit dem DC-PCVD-Verfahren hergestellten Schichten hinsichtlich ihrer Korrosions- und Wischfestigkeit weiter zu verbessern.

Diese Aufgabe wird erfindungsgemäß gelöst durch den Einsatz einer Mikrowellen-ECR-Plasmabeschichtungsquelle, wobei die zu beschichtenten Vorderflächenspiegel an einem in der Vakuumkammer befindlichen Drehkäfig befestigt sind, der mit einer frequenz- und phasenabgestimmten Planetenbewegung an einer Beschichtungsquelle vorbeiführbar ist und dadurch, daß die Beschichtungsprozesse, wie beispielsweise die Metallisierung der Substratoberfläche durch eine aufzubringende Aluminiumschicht, in der Vakuumkammer unter Plasma und bei Drücken unterhalb von $2 \times 10^{-2}$ mbar durchführbar sind.

Weitere Einzelheiten und Merkmale sind in den Patentansprüchen näher gekennzeichnet.

Die Erfindung läßt - verschiedensten Ausführungsmöglichkeiten zu; eine davon ist in den anhängenden Zeichnungen näher argestellt, und zwar zeigen:

Fig. 1    eine Vorrichtung zur Beschichtung von Vorderflächenspiegeln - bestehend im wesentlichen aus einer Mikrowellenquelle, einer Vakuumkammer mit Einbauten und einem Vakuumpumpstand - im Schnitt,

Fig. 2    eine Vorrichtung gemäß Figur 1 in der Draufsicht,

Fig. 3    eine Hornantenne und ein Ausschnitt aus einem Drehkäfig in perspektivischer Sicht,

Fig. 4    eine Vorrichtung gemäß Figur 1 mit in axialer Richtung angeordneter Plasmaquelle im Quer- und im Längsschnitt,

Fig. 5 eine Vorrichtung gemäß Figur 1 mit in azimutaler Richtung angeordneten Plasmaquellen im Schnitt, jedoch ohne Vakuumpumpstand,

Fig. 6 ein Hilfsbild zur Erläuterung der zur Berechnung der Winkelgeschwindigkeiten um die zentrale Achse und die Planeteneigenachse des Drehkäfigs notwendigen Größen und

Fig. 7 eine Anordnung der Gasverteilungsrohre in der Vakuumkammer im Schnitt.

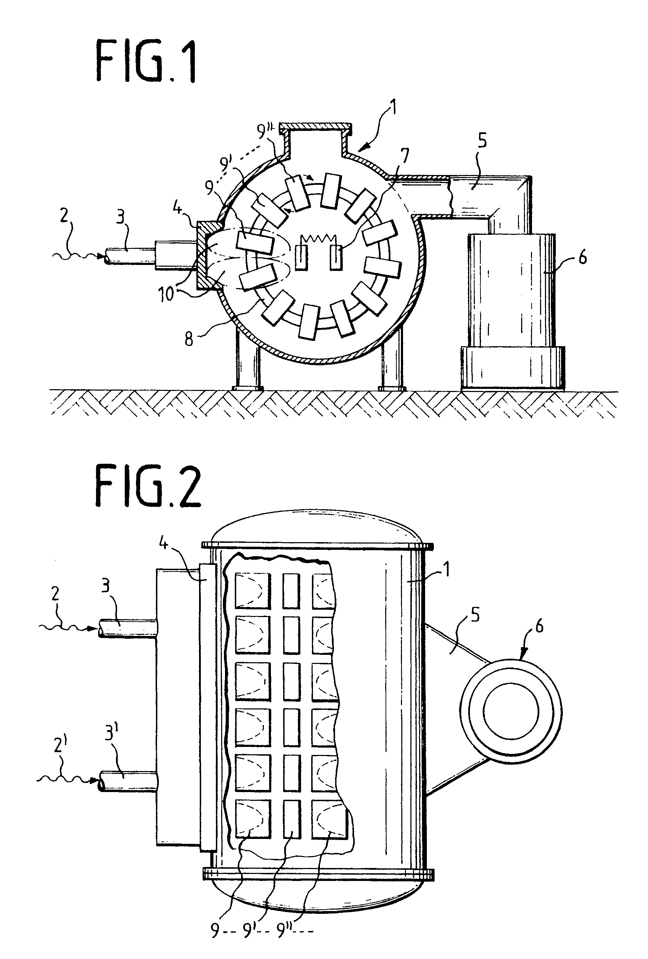

Wie Figur 1 zeigt, sind an einer zylindrischen und horizontal angeordneten Vakuumkammer 1 eine Mikrowellenquelle 2, ein Hohlleiter 3 und eine Hornantenne 4 axial auf einer Seite der Kammer angebaut und ein Verteilerkasten 5 sowie eine Hochvakuumpumpe 6 an der gegenüberliegenden Seite der Kammer angeschlossen. In der Kammer 1 ist zentral und in axialer Richtung eine Verdampferbank 7 befestigt.

Koaxial um diese Verdampferbank 7 ist ein hohlzylindrischer Drehkäfig 8 angeordnet, der die zu beschichtenden Substrate 9, 9', 9'', ... auf seinem Umfang aufnimmt und durch das in der Vakuumkammer 1 ortsfest erzeugte Plasma 10 hindurchbewegt.

An der hier gezeigten Vakuumkammer 1 sind je 2 Stück Mikrowellenquellen 2, 2' und Hohlleiter 3, 3' vorgesehen. Der Verteilerkasten 5 ist zur räumlichen Verteilung des Saugvermögens der Hochvakuumpumpe 6 an der Längsseite der Vakuumkammer 1 mittig angeschlossen. Die zu beschichtenden Substrate 9, 9', 9'', ... sind am Umfang und über die gesamte Länge des Drehkäfigs angeordnet (Figur 2).

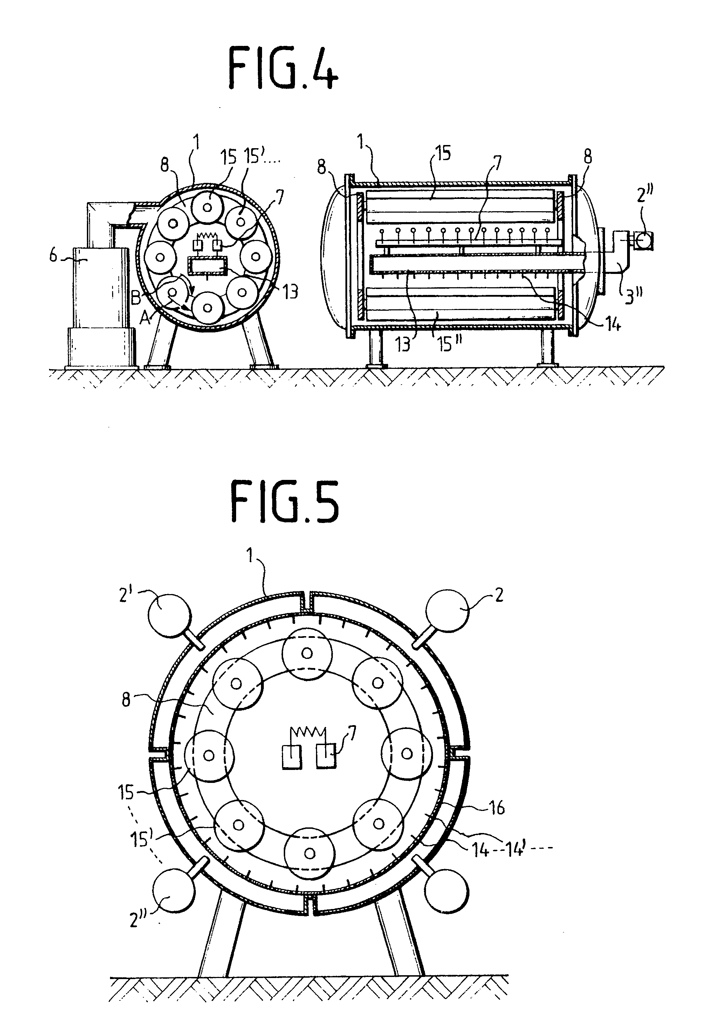

Die größere Öffnung der Hornantenne 4 ist mit einem Quarzfenster 11 abgeschlossen, an das sich die Magnetsysteme 12, 12' anschließen. Die Hornantenne 4 ist lotrecht auf die Oberfläche des Drehkäfigs 8 ausgerichtet, auf der die Substrate 9, 9', 9'', ... befestigt sind (Figur 3).

Die Mikrowellenquelle 2'' ist stirnseitig an einer Vakuumkammer 1 angeordnet und mit einem Mikrowellenhohlleiter 3'' verbunden, der wiederum an eine sich in axialer Richtung der Vakuumkammer 1 erstreckenden Mikrowellen-Antennenstruktur 13 angeschlossen ist. Diese Antenne 13 ist mit sich wiederholenden Koppelelementen 14, 14', ... versehen.

Oberhalb und parallel der Mikrowellenstruktur 13 ist eine Verdampferbank 7 angeordnet. Ein Drehkäfig 8 ist um die gedachte zentrale Kammerlängsachse in Bewegungsrichtung A drehbar gelagert. Die am Umfang des Käfigs 8 planetenartig angeordneten Haltemittel 15, 15', ... dienen zur Aufnahme der Substrate und führen eine weitere Drehbewegung in Bewegungsrichtung B um eine mit dem Käfig umlaufende Drehachse aus (Figur 4).

In Figur 5 sind die Magnetrons 2, 2', ... azimutal verteilt an der Vakuumkammer 1 befestigt und die mit den Koppelelementen 14, 14', ... versehene Mikrowellen-Antennenstruktur 16 ist koaxial zum Drehkäfig 8 und zwischen diesem und der Kammerwand angeordnet.

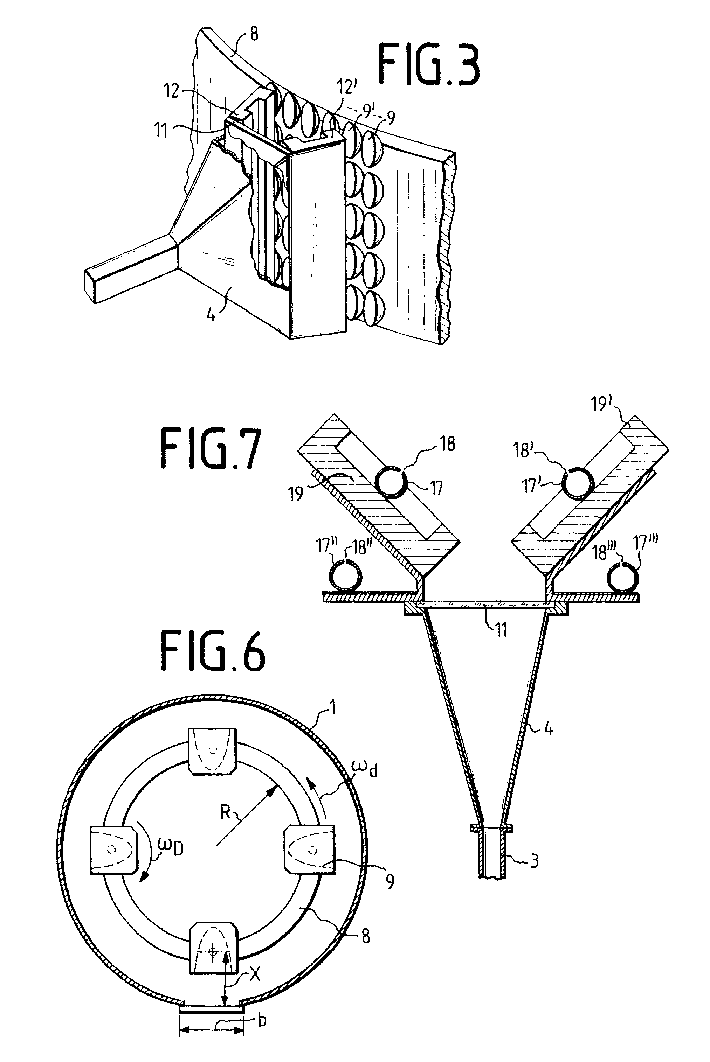

Die Winkelgeschwindigkeit um die zentrale Kammerachse $W_D$ und um die Planeteneigenachse $W_d$ sind im Drehsinn gegenläufig. Die notwendigen geometrischen Abmessungen zur Berechnung der Winkelgeschwindigkeit R, X und b sind in Figur 6 gezeigt.

Die Gasverteilungsrohre 17, 17' zur Zuführung von Prozeßgas in die Vakuumkammer sind mit sich wiederholenden Bohrungen 18, 18', ... versehen und zwischen den freien Magnetpolen 19, 19' befestigt. Ein zweites Prozeßgas wird mit Hilfe der ebenfalls in Nähe der Magnetpole 19, 19' angeordneten Gasverteilungsrohre 17'', 17''' in die Vakuumkammer eingeleitet (Figur 7).

Es wird mit Vorteil eine Mikrowellen-ECR-Plasmaquelle eingesetzt. Mit diesem Plasmagenerator wird die Energie aus einem Mikrowellenfeld (z. B. 2,45 GHz oder 900 MHz) verwendet, um die Glimmentladung aufrechtzuerhalten. Die Mikrowellen werden in einem konventionellen Magnetron erzeugt und über einen Hohlleiter in eine Antenne (z. B. eine Hornantenne) eingespeist. Diese Antenne übernimmt gleichzeitig auch die Funktion der hochvakuumdichten Trennung des Hohlleiterbereiches vom Inneren der evakuierten Prozeßkammer, an die sie angeflanscht ist (siehe Figuren 1 und 2).

Vakuumseitig wird die Antenne von einem ringförmigen Magnetjoch umrahmt, das mit Permanentmagneten bestückt ist. Dieses Magnetsystem erzeugt ein in sich geschlossenes tunnelförmiges Magnetfeld. Dieses Magnetfeld ist so dimensioniert, daß es in einem gewissen Bereich zwischen den freien Polflächen der Magnete die Elektrozyklotron-Resonanzbedingung für die verwendete Mikrowellenfrequenz erfüllt.

Durch den Resonanzeffekt wird der Energieübertrag vom Mikrowellenfeld zu den im Plasma enthaltenen Elektronen sehr effizient verstärkt. Die Folge ist eine im Vergleich zu DC- oder rf-betriebenen Plasmen äußerst hohe Reaktivität der Schwerteilchen.

Abgesehen von dem im Magnetfeld erzeugten Resonanzeffekt, vermindert das Magnetfeld auch noch Verluste durch Diffusion der Ladungsträger (containment) und erzeugt im vorliegenden Falle schließlich infolge von Driftbewegungen, die es den Ladungsträgern aufzwingt, eine Vergleichmäßigung der Entladung in Richtung der Längsachse des Magnetjoches.

Die dem Plasma ausgesetzten Flächen des Magnetsystems sind vorteilhaft ausgerüstet mit einem einfach abnehmbaren, heizbaren Schild, das in größeren zeitlichen Abständen außerhalb der Anlage gereinigt und ebenso leicht wieder montiert werden kann.

Die Antennenstruktur, durch die die Versorgung der langen Plasmazone mit Mikrowellenenergie erfolgt, kann als Hornantenne ausgeführt werden (siehe Figur 3), durch die das aus dem Hohlleiter austretende Mikrowellenfeld in die Längsrichtung des Magnetsystems aufgeweitet wird. Die größere Öffnung der Hornantenne ist mit einem Quarzfenster abgeschlossen, das als mikrowellendurchlässige Vakuumdichtung für den Rezipienten dient.

Mit Vorteil stellte sich heraus, daß diese Vorrichtung hervorragend als Plasmaquelle für die Beschichtung und Behandlung von Substraten mit kompliziert dreidimensional geformten Oberflächen geeignet ist.

Figuren 1, 4 und 5 zeigen drei verschiedene Einbaumöglichkeiten für die beschriebene Mikrowellenplasmaquelle in Beschichtungsanlagen, die eine zylindrisch geformte Prozeßkammer besitzen, in der ein Drehkäfig mit Planetengetriebe für die zu beschichtenden Teile eingesetzt ist.

Die Plasmaquelle kann in axialer Richtung, parallel zur Kammerlängsachse, wie Figuren 1 und 4 zeigen, oder azimutal, wie Figur 5 zeigt, in den Außenmantel des zylindrischen Grundkörpers der Prozeßkammer eingefügt werden. Diese beiden Versionen sind auch für In-line-Anlagen geeignet.

Der Mikrowellensender kann sowohl kontinuierlich als auch gepulst betrieben werden. Als vorteilhaft für die unten beschriebenen Prozesse hat sich der gepulste Betrieb erwiesen. In den Plasma-AUS-Zeiten findet insbesondere an strömungstechnisch ungünstigen Stellen in der Prozeßkammer und an strömungstechnisch ungünstigen Stellen kompliziert geformter dreidimensionaler Substrate ein gewünschter Gasaustausch statt, der eine Vergleichmäßigung von Schichtqualität und Ratenverteilung bewirkt.

Soll die Innenfläche von konkav geformten Substraten beschichtet werden, so müssen im Fall deR in axialer Richtung in den Außenmantel gesetzten Plasmaquelle die Winkelgeschwindigkeiten und Phasen der Planetenbewegung in bestimmter Weise aufeinander abgestimmt werden, um optimale Beschichtungsergebnisse zu erzielen. Für die Winkelgeschwindigkeit um die zentrale Achse $\omega_D$ und Winkelgeschwindigkeit $\omega_d$ um die Planeteneigenachse, gemessen relativ zum mit $\omega_D$ rotierenden Käfigsystem muß dann gelten:

$$\frac{\omega_d}{\omega_D} = \frac{-\pi}{2\left(\arccos\frac{R+x}{\delta} + \arccos\frac{R}{\delta}\right)}$$

mit

$$\delta = \sqrt{\frac{b^2}{4} + (R + x)^2}$$

Die Definition der in dem Ausdruck verwendeten Größen ist aus Figur 6 ersichtlich. Die Phasen der Rotation der Planeten um ihre eigene Achse ist durch die Bedingung festgelegt, daß die Fläche der Projektion der zu beschichtenden Innenfläche der konkaven Substrate auf eine Ebene senkrecht zur Beschichtungsrichtung im Augenblick ihrer größten Annäherung an die Beschichtungsquelle maximal ist.

Handelt es sich um eine Batchanlage ohne Ausschleuskammer, kann die Plasmaquelle entlang der geometrischen Symmetrieachse des zylindrischen Prozeßkammergrundkörpers angeordnet werden (siehe Figur 4).

Der hier beschriebene Beschichtungsprozeß ist auch in einer In-line-Anlage durchführbar, in der die Substrathalter nicht zwangsläufig eine Rotationsbewegung um eine ihnen gemeinsame Achse ausführen, sondern mittels eines Linearantriebes kontinuierlich in Anlagenlängsrichtung durch die verschiedenen Kammern gefahren werden. Die Plasmaquelle ihrerseits ist so angeordnet, daß ihre Längsachse im rechten Winkel zur Substratbewegungsrichtung verläuft.

Ein weiterer wesentlicher Vorteil der Erfindung ist die Anordnung der Gasverteilungsrohre. Es hat sich erwiesen, daß die in Figur 7 gezeigte Anordnung der Gasverteilungsrohre bei hoher Prozeßsicherheit die besten Schutzschichten erbrachte: Die Gasverteilungsrohre, die das jeweils verwendete, Silizium und Kohlenstoff enthaltende Gas dem Prozeß zuführen, werden zwischen den freien Magnetpolen montiert. Wird

EP 0 450 165 A2

ein zweites Gas, z. B. Sauerstoff, zusätzlich zum ersten eingesetzt, so kann dies ebenfalls in Jochnähe in die Prozeßkammer eingelassen werden.

Einige der für die Schutz- und die Vorbeschichtungsprozesse verwendeten Organosilizium-Verbindungen besitzen bei Raumtemperatur einen so niedrigen Dampfdruck, daß sie, um die für den Großflächenbeschichtungsprozeß notwendigen Massenflüsse sicherzustellen, auf typisch 70 bis 80 ° C aufgewärmt und bei diesen Temperaturen in einem geeigneten Verdampfer verdampft (bzw. vergast) werden müssen. Daher sind alle Monomerleitungen, die sich stromabwärts an den Verdampfer anschließen, mittels einer geeigneten Heizung auf eben dieser Temperatur zu halten. Zwecks Vergleichmäßigung der Beschichtung kann das Monomer durch ebenfalls geheizte Gasverteilungsrohre in die Prozeßkammer eingelassen werden.

Mittels einer Kaltfläche kann die Saugleistung für leicht kondensierbare Monomere/Prozeßgase, wie z. B. Trifluormethan oder Hexamethyldisiloxan, in einem goßen Bereich selektiv variiert werden, ohne daß sich die Saugleistung für Prozeßgase mit niedrigem Taupunkt nennenswert verändert. (Beispiel: A900H, Saugleistung für HMDSO zwischen 300 und 4200 l/s bei einem $O_2$-Saugvermögen von etwa 2000 l/s.) Die Saugleistung wird über die Temperatur der Kaltfläche und/oder durch ein vorgeschaltetes Ventil reguliert.

Diese Anordnung ermöglicht eine Variation der Prozeßgas/Monomermischungen und der gas-/monomerspezifischen Verweilzeiten der Prozeßgase/Monomere in der Prozeßkammer und damit eine Variation der Schichtzusammensetzung und Schichteigenschaften in einem großen Bereich.

Die Hochvakuumpumpe ist so an die Prozeßkammer angeflanscht, daß die räumliche Verteilung des Saugvermögens in Richtung der Längsachse des Plasmagenerators homogen ist. Das ist der Zweck des in Figur 1 gezeigten Kastens, der die Pumpe mit der Prozeßkammer verbindet. In Verbindung mit homogener Gasversorgung durch die Gasverteilungsrohre und homogener Plasmaerzeugung sind damit die Grundvoraussetzungen für eine ebenso homogene Beschichtung geschaffen. Insbesondere bei der Beschichtung von Formteilen, die zudem noch zusammen mit den immer notwendigen Substrathaltern in einer Planetenbewegung durch die Beschichtungszone hindurchgeführt werden, wird diese Homogenität von eben diesen Substraten jedoch unter Umständen empfindlich gestört. Und zwar ist dies um so ausgeprägter der Fall, je höher der Druck während des Beschichtungsprozesses ist, d. h. je viskoser die Strömungsverhältnisse insbesondere in der Beschichtungszone sind. Mit der eingesetzten Mikrowellen-ECR-Plasmaquelle sind nun besonders niedrige Prozeßdrücke im Bereich von $1 \times 10^{-4}$ bis $1 \times 10^{-2}$ mbar zugänglich, für die die Strömung zwischen Beschichtungsquelle und Substraten nahezu molekular werden kann.

Die Messung zeigte nun, daß die Depositionsrate bei diesen niedrigen Drücken nicht nur noch befriedigend hoch war, sondern daß auch - und zwar ebenfalls bei diesen niedrigen Drücken - die Schichtqualität hervorragend war. Aufgrund der oben erläuterten engen, für die vakuumtechnische Großflächenbeschichtung typischen Randbedingungen ist nicht viel Raum für die Optimierung des Prozesses gewesen; insofern war das gute Ergebnis überraschend. Ebenfalls der Homogenisierung der räumlichen Ratenverteilung auf dreidimensionalen Substraten dient im Fall der Verwendung eines Drehkäfigs die oben schon erwähnte genaue Abstimmung der Phasen und Frequenzen der beiden Rotationsbewegungen, aus denen sich die Planetenbewegung zusammensetzt.

In die Anlage integriert ist eine je nach elektrischer Leitfähigkeit der Substratoberfläche rf- bzw. mf- oder eine DC-Biasversorgung, die über den gegen Masse isolierten Käfig den Substratoberflächen positives Potetial (Bias) aufprägt. Damit ist ionenunterstützte Abscheidung von besonders dichten und harten Schichten möglich.

Durch den Metallisierungsprozeß kann auch bei dielektrischen Substraten eine leitende Oberfläche erzeugt werden, die gleichzeitig den elektrischen Kontakt zum Drehkäfig herstellt. Damit wird auch bei dielektrischen Substratmaterialien eine ionenunterstützte Abscheidung möglich.

Dem Zweck der Verdichtung und Härtung der sich abscheidenden Schicht dient eine in die Einschleuskammer eingebaute Heizung, mit der die Temperatur ausreichend hitzebeständiger Substrate schon während der Schleusenkonditionierung gesteigert werden kann. In der Prozeßkammer ist eine Halteheizung installiert, die die Substrattemperatur während des Beschichtungsprozesses stabilisiert. Dabei ist auch beabsichtigt, daß sich die Wände und die Einbauten der Prozeßkammer ebenfalls aufheizen. Denn die Folge ist, daß die sich dort abscheidenden Schichten besonders gut haften und sich erst nach deutlich verlängerter Betriebszeit der Anlage von ihrer Unterlage lösen. Die Prozeßkammerheizung verlängert also das Zeitintervall zwischen zwei Reinigungszyklen und also die Produktivität der Gesamtanlage.

Das erfindungsgemäße Verfahren ist in die folgenden Verfahrensschritte zu unterteilen:

1. Plasmaunterstützte Vorbehandlung der Substratoberfläche bei folgenden Parametern: Zusammensetzung der Gasatmosphäre: Eine (per)fluorierte Kohlenstoffverbindung, z. B. $CF_4$ bei einem Partialdruck zwischen 0,1 $\mu$bar und 1 mbar und Sauerstoff bei einem Partialdruck zwischen 0,25 $\mu$bar und 1 mbar; Mikrowellenleistung zwischen 100 W und 1 kW pro 0,5 m Plasmalänge; kein zusätzliches Substratpotential, Saugvermögen zwischen 100 l/s und 2000 l/S/Stickstoff pro 0,5 m Plasmalänge; Abstand der Substratoberflächen zur Plasmaquelle zwischen 2 cm und 1 m. Behandlungsdauer zwischen 10 sec und 2 min.

Der Effekt dieser Vorbehandlung ist eine deutlich gesteigerte Haftfestigkeit der nachfolgend aufgebrachten Schicht zur Substratoberfläche. Inwiefern sich diese verbesserte Haftung in einer gesteigerten Korrosionsfestigkeit des Endproduktes auswirkt, wird weiter unten erklärt.

2. Nichtbeschichtende Plasmavorbehandlungen in einer sauerstoffhaltigen oder/und stickstoffhaltigen Atmosphäre bei einem Prozeßdruck zwischen $2 \times 10^{-2}$ mbar und 1 mbar, Mikrowellenleistung zwischen 100 W und 1 kW pro 0,5 m Plasmalänge, Saugvermögen zwischen 100 l/s und 2000 l/s$_{Sauerstoff}$, Abstand der Substratoberflächen zur Plasmaquelle zwischen 5 cm und 1 m. Behandlungsdauer zwischen 0,1 sec und 10 sec, Prozeßgase z. B. $O_2$, $H_2O$, $N_2O$, $NH_3$ oder $N_2$.

Diese Vorbehandlung bewirkt eine Funktionalisierung der Substratoberfläche. Das heißt, auf der Substratoberfläche werden funktionelle Gruppen erzeugt, wie z. B Hydroxyl-, Carbonyl- oder Aminogruppen. Das Ergebnis dieser Oberflächenmodifikation ist eine verbesserte Haftfestigkeit nachfolgender Schichten.

3. Heizung der Substrate auf die höchste für das gegebene Substratmaterial zulässige Temperatur, jedoch weniger als 300 °C.

### 4. Egalisierungsschicht

Aufbringen einer ca. 1 - 5 $\mu$m dicken PCVD-Schicht, die einen rauhe Oberflächen einebnenden Effekt hat. Der Vorteil gegenüber naßchemisch aufgebrachten Lacken ist, daß die PCVD-Schichten hitzebeständig bis 600 °C sein können; aufgrund der langen Prozeßzeit allerdings nur für Substrate mit hoher Wertschöpfung geeignet.

5. Beschichten der so vorbehandelten oder auch nicht vorbehandelten Oberflächen mit einer Haftvermittlungschicht zum Aluminium bei folgenden Prozeßparametern: Zusammensetzung der Gasatmosphäre:

Eine nur oder hauptsächlich Silizium, Kohlenstoff und Wasserstoff enthaltende Organosilizium-Verbindung, wie z. B. Tetramethylsilan oder Hexamethyldisiloxan, bei einem Partialdruck zwischen 0,1 $\mu$bar und 10,0 $\mu$bar oder ein Silan, z. B. Disilan, gemischt mit einem Kohlenwasserstoff, z. B. $CH_4$, $C_2H_2$, Benzol, oder einer Organosilizium-Verbindung, auch zusammen mit einem sauerstoffhaltigen Gas, wie z. B. $N_2O$, bei einem Druck des Gasgemisches zwischen 0,1 $\mu$bar und 12 $\mu$bar; Mikrowellenleistung zwischen 200 W und 2 kW pro 0,5 m Plasmalänge, zusätzliche Substratvorspannung $<= 100$ V, Saugvermögen zwischen 600 l/s und 2000 l/s$_{Stickstoff}$ und zwischen 300 l/s und 4000 l/s$_{Hexamethyldisiloxan}$ pro 0,5 m Plasmalänge, Abstand zwischen Plasmaquelle und Substratvorderkante zwischen 2 cm und 20 cm, Bedingungen für die Zusammensetzung der Schicht, bezogen auf Silizium, Kohlenstoff und Sauerstoff: Si: $> 20$ at%, C $< 50$ at%, O $< 30$ at% , Schichtdicke zwischen 20 Å und 800 Å.

Der Sinn dieser Vorbehandlung ist eine weitere Steigerung der Haftfestigkeit der im nächsten Prozeßschritt aufzubringenden Metallschicht auf der Unterlage. Die haftungsvermittelnde Wirkung ist insbes. für die Korrosionsfestigkeit des Schichtsystems von Bedeutung. Gute Haftung verhindert das Eindringen agressiver Medien, ausgehend von Pin-windows im oder mechanischen BeSchädigungen des Schichtsystems, zwischen Aluminiumschicht und die Vorbeschichtung bzw. zwischen Aluminiumschicht und die Substratoberfläche durch Kapillarwirkung. Die dem korrosiven Medium ausgesetzte Aluminiumoberfläche wird somit minimiert.

### 6. Metallisierung

Beschichten der so vorbeschichteten Substrate mit einer zwischen 700 A° und 2 $\mu$m dicken Aluminiumschicht entweder durch Aufdampfen oder durch Sputtern. Handelt es sich um Substrate mit kompliziert dreidimensional geformten Oberflächen, die auch Hinterschneidungen besitzen können, die ebenfalls beschichtet werden müssen, so ist beim Sputtern ein Sputtergasdruck von mehr als 6 $\mu$bar eines möglichst schweren Edelgases, dessen Preis noch vertretbar ist, nämlich Krypton, zu bevorzugen.

### 7. Nichtbeschichtende Plasma-Nachbehandlung der Metallschicht

Oberflächliche Oxidation der Aluminiumschicht mittels Plasma in einer sauerstoffhaltigen Prozeßatmosphäre. Prozeßgase, z. B. Sauerstoff, Wasser oder Stickoxidul, auch zusammen mit anderen Prozeßgasen wie z. B Helium oder Argon, Prozeßdrücke zwischen 0,1 $\mu$bar und 1 mbar, Saugvermögen zwischen 300 und 2000 l/S$_{Sauerstoff}$ pro 0,5 m Plasmalänge, Prozeßzeit $\leq$ 1 min. Der Prozeß bewirkt eine verbesserte Abrasionsfestigkeit der Aluminiumschicht.

### 8. Schutzbeschichtung

8.1 Beschichtung der zuvor metallisierten Substrate in einem weiteren PCVD-Prozeß bei folgenden Parametern: Ein Silizium, Kohlenstoff, Sauerstoff und Wasserstoff enthaltendes Gas einer Organosilizium-Verbindung, wie z. B. Hexamethyldisiloxan (HMDSO), Tetramethyldisiloxan (TMDS), Tetramethylcyclotetrasiloxan, Tetraethoxisilan (TEOS), .... bei einem Partialdruck zwischen 0,1 $\mu$bar und 10 $\mu$bar, Sauerstoff bei einem Partialdruck zwischen 0 $\mu$bar und 9,9 $\mu$bar, oder ein Silan, z. B. Monosilan, bei einem Partialdruck zwischen 0.1 μbar und 6 μbar und ein Sauerstoffträger, wie z.B. Stickoxidul (N₂O), bei einem Partialdruck zwischen 0,1 und 9,9 μbar, auch mit einem Kohlenwasserstoff, z. B. Hexan oder einer Organosilizium-Verbindung, bei einem Partialdruck zwischen 0,5 und 8 μbar, Mikrowellenleistungen zwischen 200 W und 2 kW pro 0,5 Plasmalänge, zusätzliche Substratbias < = 600 V, Saugvermögen zwischen 600 l und 2000/Stickstoff und zwischen 300 l/s und 4000 l/S/Hexamethyldisiloxan pro 0,5 m Plasmalänge, einem Substratabstand zur Plasmaquelle zwischen 2 cm und 20 cm und einer zu erzielenden Schichtdicke zwischen 80 Å und 1000 Å. Bedingungen für die Zusammensetzung der Schicht, bezogen auf Sauerstoff, Silizium und Kohlenstoff: Sauerstoffgehalt > 20 at%, Siliziumgehalt > 20 at%, Kohlenstoffgehalt zwischen 60 at% und 30 at% .

Diese Schicht besitzt eine gegenüber den mit der herkömmlichen Methode hergestellten eine etwa doppelt so große Korrosionsfestigkeit in den Korrosionstests (siehe unten).

8.2 Beschichten des schutzbeschichteten Substrates mit einem fluorierten Toplayer bzw. fluorierte Schutzbeschichtung (weiterer PCVD-Prozeß). Parameter: Ein Silizium, Kohlenstoff, Sauerstoff und Wasserstoff enthaltendes Gas einer Organosilizium Verbindung, wie z.B. Tetramethyldisiloxan, Tetraethoxisilan, ... bei einem Partialdruck zwischen 0,1 μbar und 10 μbar oder ein Gemisch aus einem Silan, z.B. Disilan, bei einem Partialdruck zwischen 0,1 und 10 μbar und einem Sauerstoffträger, z. B. N₂O, bei einem Partialdruck zwischen 0 und 9,9 μbar, Zugabe eines (per)fluorierten Gases, z. B. Tetrafluormethan, Hexafluorpropen,... oder eine fluorierte Organosilizium-Verbindung, wie z. B. Methyltrifluorosilan, mit oder ohne Zugabe von Sauerstoff bei einem Partialdruck zwischen 0 μbar und 9,9 μbar, Mikrowellenleistungen zwischen 200 W und 2 kW pro 0,5 Plasmalänge, zusätzliche Substratbias < = 200 V, Saugvermögen zwischen 600 l und 2000/Stickstoff und zwischen 300 l/s und 4000 l/S/Hexamethyldisiloxan pro 0,5 m Plasmalänge, einem Substratabstand zur Plasmaquelle zwischen 2 cm und 20 cm und einer zu erzielenden Schichtdicke zwischen 80 Å und 1000 Å. Zweck dieser Schicht ist eine Verbesserung der Korrosionseigenschaften (chemische Inertisierung) der Schutzschicht sowie eine Verbesserung der optischen Eigenschaften der Schutzschicht (Herabsetzung des Brechungsindex und Verbesserung der Reflektion) durch Fluoreinbau. 8.3 Beschichten des schutzbeschichteten Substrates mit einem hydrophilen Toplayer bei folgenden Parametern: Eine möglichst sauerstoffreiche Organosilizium-Verbindung, z.B. TEOS, .... oder auch HMDSO bei einem Partialdruck zwischen 0,1 μbar und 2 μbar oder ein Silan, z. B. Monosilan, bei einem Partialdruck zwischen 0,1 und 9 μbar; Sauerstoff bei einem Partialdruck zwischen 1 μbar und 10 μbar; Wasser bei einem Partialdruck zwischen 1 μbar und 15 μbar, Mikrowellenleistung zwischen 100 W und 2 kW pro 0,5 m Plasmalänge; zusätzliches Substratpotential < = 200 V, Saugvermögen zwischen 600 1/sec und 2000 l/s/Stickstoff und zwischen 300 l/s und 2000 l/s/Hexamethyldisiloxan (selektive Variation des Saugvermögens für leicht kondensierbare Monomere (siehe unten) pro 0,5 m Plasmalänge, Substratabstand zur Plasmaquelle zwischen 2 cm und 30 cm, Schichtdicke bis 2 μm, vorzugsweise 50 Å.

Der Zweck dieser Schicht ist, die besonders korrosionsfeste, im vorhergehenden Prozeßschritt hergestellte und im allgemeinen nichthydrophile Schicht mit einer hydrophilen Schicht zu überdecken. Kondenswassertropfen, die sich bei Gebrauch des fertigen Produktes auf der in obengenannter Weise hydrophilierten aktiven Fläche sammeln, verlaufen innerhalb kurzer Zeit und vereinigen sich zu einem geschlossenen Wasserfilm, der die optische Funktion der Reflektorinnenfläche nicht merklich beeinträchtigt - im Gegensatz zu einer Vielzahl dicht beieinandersitzender Kondenswassertröpfchen. Außerdem ergibt sich durch die Vermeidung bzw. Verkleinerung der Phasengrenze Luft/Wasser/Schutzschicht eine Verminderung des korrosiven Angriffs auf das Schichtpaket und damit eine verlängerte Lebensdauer.

8.4 Zum gleichen Zweck kann eine wie in Punkt 8.1 erzeugte SiC- bzw. SiCO-Schutzbeschichtung in einer sauerstoffhaltigen Atmosphäre durch Plasmabehandlung oberflächlich oxidiert werden. Anordnung wie oben, Prozeßgas; z. B. O₂ oder N₂O, Druck 1 x 10⁻⁴ mbar bis 1 mbar, zusätzliche Substratvorspannung ≤ 800 V, Saugvermögen 400 bis 2400 l/s/Sauerstoff pro 0,5 m Plasmalänge, Mikrowellenleistung zwischen 500 W und 3,5 kW pro 0,5 m Plasmalänge, Abstand zwischen Plasmaquelle und Substratvorderkante zwischen 20 mm und 40 cm.

8.5 Für die PCVD-Beschichtung unter den Punkten 4, 5, 8.1, 8.2 und 8.3 kann durch Beimischung von Metallen in Form von Metallhalogeniden, z. B. Wolframhexafluorid, Metallorganika, z. B. Diethylzinc oder Eisenpentacarbonyl zum Prozeßgas oder durch gleichzeitiges Verdampfen oder Kathodenzerstäuben (Sputtern) von Metallen, wie z. B. Platin oder Kupfer, auch zusammen mit Wasserdampf und/oder Sauerstoff eine katalytische Wirkung erzielt werden. So wirkt beispielsweise die Zugabe von Kupfer katalytisch auf die Verbindung von Silizium und Kohlenstoff.

Das beschriebene Verfahren und die Vorrichtung weisen eine Vielzahl von Vorteilen auf; dies sind im einzelnen:

1. Die Ergebisse der nach FIAT-Norm 5.00435 an Kfz-Reflektoren durchgeführten Korrosionstests (siehe unten) zeigen mit Vorteil, daß die nach dem hier mitgeteilten Verfahren beschichteten Teile, selbst wenn sie im Batch-Verfahren hergestellt worden sind, eine typisch dreimal so hohe Standzeit im jeweiligen korrosiven Medium besitzen als die nach dem herkömmlichen Verfahren mit der DC-PCVD hergestellten Teile.

Das Aufprägen von zusätzlichem Potential auf die Substratoberfläche und/oder die Wirkung einer Substrattemperatur von wenigstens 70 °C verleiht den ohnedies gut wischfesten Schichten noch eine erhöhte Dichte und weiter verbesserte Korrosions- und Abrasionsfestigkeit.

2. Die außerordentlich große Korrosionsbeständigkeit ermöglicht die Reduktion der Schichtdicken auf 100 Å, i. e. ca. ein Drittel der herkömmlichen. Dies wirkt sich vorteilhaft in einer Steigerung des Reflektionsvermögens und der Freiheit von Interferenzfarben der Reflektorschutzschicht aus.

3. Vorrichtung und Verfahren der hier mitgeteilten Erfindung sind kontinuierlich betreibbar. Daher

a) kann die Vorrichtung in kontinuierlich und daher kostengünstig zu betreibende Durchlaufanlagen integriert werden,

b) ist die beim Fluten der Prozeßkammer auftretende Kontamination der Prozeßkammerwände, der Prozeßatmosphäre und schließlich auch der Substratoberflächen mit Feinstaub deutlich geringer als beim herkömmlichen Verfahren mit der DC-PCVD. Dies wiederum hat zur Folge, daß die erfindungsgemäß hergestellten Schichten weitgehend fehlstellenfrei aufwachsen.

4. Nach einer gegenüber der herkömmlichen Technik deutlich verlängerten Standzeit der Anlage ist eine Reinigung zunächst nur der unmittelbaren Umgebung des Plasmagenerators notwendig, der übrige Teil der Prozeßkammer, der etwa benutzte Drehkäfig eingeschlossen, muß nicht notwendigerweise gereinigt werden. Auch dies steht im Gegensatz zum gegenwärtigen Stand der einschlägigen Anlagentechnik, mit der ein deutlich höherer Aufwand für Reinigungsprozeduren in Kauf genommen werden muß.

5. Die Erfindung betrifft Vorrichtungen und Verfahren in der Vakuumverfahrenstechnik zur Behandlung oder Beschichtung von Großflächen mit typischen Abmessungen in der Größenordnung eines Meters. Typische Abstände zwischen Einbauten und zwischen Einbauten und den Rezipientenwänden liegen in der Größenordnung von 20 cm bis ebenfalls ca. einem Meter. Reproduzierbare Verhältnisse, die lokalen Strömungsverhältnisse, die lokalen Aufenthaltsdauern und die lokalen Partialdruckverhältnisse der verwendeten gasförmigen Edukte und ihrer gasförmigen Produkte sowie auch das Ausmaß an Feinstaubgeneration durch die sogenannte Volumenpolymerisation betreffend, sind in den meisten Fällen nur dann erreichbar, wenn es möglich ist, in dem für die gegebene (Groß-)Anlage molekularen oder wenigstens schwach viskosen Druckbereich zu arbeiten. Für die oben angegebenen typischen Dimensionen der hier in Rede stehenden Anlagen bedeutet dies eine mittlere freie Weglänge von wenigstens 30 cm; das entspricht Drücken von nicht viel mehr als 1 $\mu$bar.

Die erfindungsgemäß eingesetzte Beschichtungsquelle ermöglicht für die PCVD-Beschichtungsprozesse Drücke einzustellen, die tatsächlich in dieser Größenordnung liegen. Dies ist mit der DC-PCVD nicht erreichbar.

6. Eine weitere vorteilhafte Konsequenz stellt das überraschende Resultat dar, z. B. bei einem Partialdruckverhältnis zwischen OrganosiliziumVerbindung (z. B. TEOS oder HMDSO) und Sauerstoff von etwa 1 : 3 und einem Totaldruck von ca. 1 $\mu$bar eine Schichtdickenhomogenität innerhalb eines ca. 30 cm tiefen statisch beschichteten Paraboloides von 1 : 1,1 - bezogen auf die Schichtdicken im Scheitelpunkt und am äußersten Rand - erreicht worden sind. Bei deutlich höheren Drücken und geringerem Sauerstoffanteil betrug die Schichtdickenhomogenität immerhin noch 1 : 2.

7. Die Wirkung der oben beschriebenen, vor der Aluminisierung durchzuführenden Vorbehandlung und Vorbeschichtung wurde durch Versuche in der Art des im folgenden Beschriebenen demonstriert.

Reflektorgrundkörper mit einer ca. 2 Monate alten Grundlackierung, die infolge schlechter Lagerbedingungen stark mit Staub kontaminiert waren, wurden erfindungsgemäß mit der oben beschriebenen Mikrowellenplasmaquelle in einer fluor/kohlenstoff/sauerstoffhaltigen Atmosphäre vorbehandelt, mit einer SiC:H- oder einer SiCO:H-Schicht vorbeschichtet, aluminisiert und mit einer Schutzschicht vom Typ SiCO:H schutzbeschichtet; ein Parametersatz wird im nächsten Abschnitt beispielhaft genauer aufgelistet. Ein zweiter, ebenso kontaminierter Reflektor wurde ebenso prozessiert, allerdings ohne die Vorbehandlung und die Vorbeschichtung. Beide Proben wurden im Natronlauge-Test gemäß obengenannter FIAT-Norm aufihre Korrosionsfestigkeit hin geprüft. Der ohne Vorbehandlung aluminisierte Reflektor hielt nur eine viertel Stunde stand, auf dem vorbehandelten dagegen waren jedoch nach einer Prüfdauer von über fünfzehn Stunden noch keine Beschädigungen zu erkennen.

Zur weiteren Erläuterung seien noch die folgenden Ausführungsbeispiele für Verfahren und Vorrichtung erwähnt:

1. LH-Anlage A900H - Batch-Anlage 0,9 m Durchmesser mit Drehkäfig, Mikrowellenquelle mit Hornantenne axial in Außenwand installiert, als Substrate Kfz-Scheinwerferreflektoren, vorlackiert, 3 Monate alt, sauber, aber nicht staubfrei gelagert, nicht vorgereinigt, Saugvermögen 2000 l/s$_{N2}$ und 3000 l/s$_{HMDSO}$,

Hintergrunddruck $1 \times 10^{-4}$ mbar, Partialdruck TMS 1,00 $\mu$bar, Mikrowellenleistung 1 kW, Käfig 10 U/min, 1 min Beschichtungsdauer; wieder auf Hintergrunddruck abpumpen, Aluminiumverdampfen für ca. 1500 A Schichtdicke, Partialdruck HMDSO 0,8 $\mu$bar, Sauerstoffpartialdruck 0,2 $\mu$bar, Mikrowellenleistung 1 kW, Käfig 10 U/min, Beschichtungsdauer 3 min, Fluten.

Korrosionstest in 0,2 % NaOH-Lösung: Nach 15h Prüfdauer waren bei keinem der 5 beschichteten Reflektoren mit bloßen Auge Beschädigungen zu erkennen. Schwitzwassertest bei 40 °C: Nach 6 Wochen waren bei keinem der Reflektoren Beschädigungen zu erkennen. Prüfung des Reflektionsvermögens: Im räumlichen und spektralen (400 nm bis 750 um) Mittel 85 %.

2. Anlage, Anordnung und Substrate wie oben, Partialdruck HMDSO 0,25 $\mu$bar, Partialdruck Sauerstoff 1,0 $\mu$bar, statische Beschichtung bei Mikrowellenleistung 1 kW.

Ausmessen der Ratenverteilung innerhalb der Reflektoren ergibt als Verhältnis der Schichtdicken an dem der Quelle am nächsten gelegenen Rand und an der der Quelle am weitesten entfernten Lampenfassung 1,2 : 1,0.

Bei Beschichtung mit bewegtem Käfig ergibt dieselbe Messung ein Schichtdickenverhältnis von 2,3 : 1,0.

3. Anordnung, Anlage, Substrate und Prozess wie unter 1; es schließt sich jedoch noch folgender Prozeß an: Partialdruck TEOS 0,1 $\mu$bar, Partialdruck Sauerstoff 4 $\mu$bar, Partialdruck Wasser 4 mbar.

Messung des Kontaktwinkels zu Wasser ergibt $< = 15°$.

4. Anordnung, Anlage, Substrate und Prozeß wie unter 1 bis einschließlich Aluminisierung. Danach folgt ein Schutzbeschichtungsprozeß : Partialdruck HMDSO = 1,0 mbar, Partialdruck CF$_4$ = 0,2 $\mu$bar, Käfigdrehzahl n = 10 x min$^{-1}$, Mikrowellenleistung = 1,0 kW, Saugvermögen 700 l/s/$_{HMDSO}$ und 1000 l/s/$_{CF4}$, Beschichtungsdauer 160 s, Fluten.

Prüfung des Reflektionsvermögens: Im räumlichen und spektralen (400 nm bis 750 nm) Mittel 88 %. Korrosionsbeständigkeit gegenüber einem Vergleichssubstrat mit nichtfluorierter Schutzbeschichtung um 23 % verbessert.

## Auflistung der Einzelteile

| | |
|---|---|
| 1 | Vakuumkammer |
| 2, 2' | Mikrowellenquelle (Magnetron) |
| 3, 3' | Hohlleiter |
| 4 | Hornantenne |
| 5 | Verteilerkasten |
| 6 | Hochvakuumpumpe |
| 7 | Verdampferbank |
| 8 | Drehkäfig |
| 9, 9', 9'', ... | Substrate (Vorderflächenspiegel) |
| 10 | Plasma |
| 11 | Quarzfenster |
| 12, 12' | Magnetsystem |
| 13 | Mikrowellenantennenstruktur |
| 14, 14', ... | Koppelelemente |
| 15, 15', ... | Haltemittel |
| 16 | Mikrowellenantennenstruktur |
| 17, 17', ... | Gasverteilungsrohre |
| 18, 18', ... | Bohrung |
| 19, 19' | Magnetpole |
| A | Bewegungsrichtung |
| B | Bewegungsrichtung |
| D | Winkelgeschwindigkeit um die zentrale Kammerachse |
| d | Winkelgeschwindigkeit um die Planeteneigenachse |
| R, X, b | geometrische Abmessungen |

## Definitionen:

| | |
|---|---|
| Batch-Anlage | diskontinuierlich zu betreibende Einkammeranlage |
| PCVD | Plasma Chemical Vapour Deposition |
| ECR | Electron Cyclotron Resonanz |

In-line-Anlage    kontinuierlich zu betreibende Mehrkammeranlage

**Patentansprüche**

1.  Vorrichtung zur Herstellung von Schichten auf der Oberfläche von Werkstücken, vorzugsweise von aus Kunststoffen gebildeten Scheinwerfer-Reflektoreinsätzen, in einer als Batchanlage zu betreibende Vakuumkammer (1) mit einem PCVD-Beschichtungsverfahren, **gekennzeichnetdurch** eine Mikrowellen-ECR-Plasmabeschichtungsquelle,wobei das Mikrowellenfeld vorzugsweise mit einer Frequenz von 2,45 GHz zu betreiben ist und die zu beschichtenden Vorderflächenspiegel (9, 9', ...) an einem in der Vakuumkammer befindlichen Drehkäfig (8) befestigt sind, der mit einer frequenz- und phasenabgestimmten Planetenbewegung an einer Beschichtungsquelle vorbeiführbar ist.

2.  Vorrichtung nach Anspruch 1, **dadurchgekennzeichnet**, daß die Mikrowellen-ECR-Plasmabeschichtungsquelle in einer In-line-Anlage einsetzbar ist.

3.  Vorrichtung nach Anspruch 1 oder 2, **dadurchgekennzeichnet**, daß der zur Erzeugung des Plasmas (10) notwendige Mikrowellensender (2) im gepulsten Betrieb einsetzbar ist.

4.  Vorrichtung nach Anspruch 1 oder 2, **dadurchgekennzeichnet**, daß der zur Erzeugung des Plasmas (10) notwendige Mikrowellensender (2) im kontinuierlichen Betrieb einsetzbar ist.

5.  Vorrichtung nach einem oder mehreren der vorhergehenden Ansprüche, **dadurchgekennzeichnet**, daß eine selektive Variation des Saugvermögens der mit der Vakuumkammer (1) verbundenen Hochvakuumpumpe ermöglicht wird, wozu vorzugsweise der Vakuumpumpe (6) ein regelbares Ventil vorgeschaltet ist.

6.  Vorrichtung nach einem oder mehreren der vorhergehenden Ansprüche, **dadurchgekennzeichnet**, daß die das Prozeßgas führenden, geheizten Gasverteilungsrohre (17, 17', ...) zwischen den freien Magnetpolen (19, 19') in der Vakuumkammer (1) montiert sind.

7.  Vorrichtung nach einem oder mehreren der vorhergehenden Ansprüche, **dadurchgekennzeichnet**, daß in der Anlage eine Biasversorgung integrierbar ist, die über den gegen Masse isolierten Käfig (8) den Substratoberflächen ein positives Potential aufprägt.

8.  Verfahren zur Herstellung von Schichten auf der Oberfläche von Werkstücken, vorzugsweise von aus Kunststoffen gebildeten Scheinwerfer-Reflektoreinsätzen, in einer als Batchanlage zu betreibenden Vakuumkammer (1) mit einem PCVD-Beschichtungsverfahren, **dadurchgekennzeichnet**, daß die Beschichtungsprozesse, wie beispielsweise die Metallisierung der Substratoberfläche durch eine aufzubringende Aluminiumschicht, in einer Vakuumkammer (1) unter Plasma und bei Drücken unterhalb von $2 \times 10^{-2}$ mbar durchführbar sind.

9.  Verfahren nach Anspruch 8, **dadurchgekennzeichnet**, daß die Substratoberfläche in einer $CF_4/O_2$-Gasatmosphäre mit Plasmaunterstützung vorbehandelt ist.

10. Verfahren nach Anspruch 9, **dadurchgekennzeichnet**, daß eine Oberflächenmodifikation des Substrats (9, 9', ...) mit O- und N-haltigen Plasmen stattfindet.

11. Verfahren nach Anspruch 10, **dadurchgekennzeichnet**, daß eine Egalisierungsschicht, wie vorzugsweise eine SiCO-Schicht, auf die Substratoberfläche aufgebracht ist.

12. Verfahren nach Anspruch 11, **dadurchgekennzeichnet**, daß eine Haftvermittlungsschicht aus einer SiC- und SiCO-Gasatmosphäre auf die Substratoberfläche aufgebracht ist.

13. Verfahren nach Anspruch 12, **dadurchgekennzeichnet**, daß eine oberflächliche Oxidation der Aluminiumschicht mittels Plasma 10 in einer $O_2$-haltigen Prozeßatmosphäre stattfindet.

14. Verfahren nach Anspruch 13, **dadurchgekennzeichnet**, daß eine Schutzschicht aus einer SiC- bzw. einer SiCO-Schicht auf das metallisierte Substrat (9, 9', ...) aufgebracht ist.

15. Verfahren nach Anspruch 14, **dadurchgekennzeichnet,** daß auf die Substratoberfläche eine vorzugsweise fluorierte SiC-Schicht aufgebracht ist.

16. Verfahren nach Anspruch 15, **dadurchgekennzeichnet,** daß unter Einlaß von Wasser in die Vakuumkammer eine Silikat- oder Quarzschicht als Deckschicht auf das Substrat (9, 9', ...) aufbringbar ist.

17. Verfahren nach Anspruch 13, **dadurchgekennzeichnet,** daß eine SiC- bzw. SiCO-Schutzbeschichtung in einer in der Vakuumkammer eingestellten $O_2$-haltigen Atmosphäre oberflächlich oxidierbar ist.

18. Verfahren nach den Ansprüchen 11, 12, 14, 15 und 16, **dadurchgekennzeichnet,** daß die Beimischung von Metallen in die in der Vakuumkammer herrschenden Atmosphäre eine katalytische Wirkung des PCVD-Prozesses hat.

# FIG.1

# FIG.2

# FIG.4

# FIG.5

FIG.3

FIG.7

FIG.6